# EUROPÄISCHE PATENTSCHRIFT

(11) **EP 0 855 088 B1**
(45) Veröffentlichungstag und Bekanntmachung des Hinweises auf die Patenterteilung: **24.02.1999**
(21) Anmeldenummer: 96933442.4
(22) Anmeldetag: 02.10.1996
(51) Int. Cl.: H01L 21/762

(54) **VERFAHREN ZUM ERZEUGEN EINER GRABENISOLATION IN EINEM SUBSTRAT**
PROCESS FOR PRODUCING TRENCH INSULATION IN A SUBSTRATE
PROCEDE DE REALISATION D'UNE TRANCHEE D'ISOLATION DANS UN SUBSTRAT

(30) Priorität: 12.10.1995 DE 19538005
(43) Veröffentlichungstag der Anmeldung: 29.07.1998
(73) Patentinhaber: FRAUNHOFER-GESELLSCHAFT ZUR FÖRDERUNG DER ANGEWANDTEN FORSCHUNG E.V., 80636 München (DE); Muth, Werner, 81373 München (DE)
(72) Erfinder: MUTH, Werner, D-81373 München (DE)
(74) Vertreter: Schoppe, Fritz, Dipl.-Ing.
(86) Internationale Anmeldenummer: EP9604304
(87) Internationale Veröffentlichungsnummer: WO9714182

(56) Entgegenhaltungen:
- EP-A- 0 656 651
- WO-A-93/10559
- WO-A-93/26041
- DE-A- 4 404 757
- US-A- 5 362 667
- US-A- 5 445 988

## Beschreibung

Die vorliegende Erfindung bezieht sich auf ein Verfahren zum Erzeugen einer Grabenisolation in einem Substrat.

Im Stand der Technik sind der Anwendung integrierter Halbleiterschaltungen, insbesondere CMOS-Schaltungen auf einkristallinem Silizium-Grundmaterial, sogenanntem bulk silicon, hinsichtlich des Einsatzes bei hohen Umgebungstemperaturen Grenzen gesetzt. Bei Leistungsbauelementen ergeben sich Anwendungsgrenzen durch die Verlustleistung des Bauelements, die im Betrieb eine erhöhte Kristalltemperatur zur Folge hat. Die maximal erreichbare Spannungsfestigkeit ist hierbei durch die Sperreigenschaft der pn-Übergänge und durch den sogenannten Latch-up Effekt beschränkt.

Die Ursache dieser Begrenzungen ist zu einem wesentlichen Teil darin zu suchen, daß bei konventionellen Schaltungen die elektrische Isolationen der die Schaltung bildenden Bauelemente untereinander durch gesperrte pn-Dotierungsübergänge bewirkt wird. Dadurch ist einerseits eine Spannungsgrenze durch die Durchbruchspannung dieser pn-Übergänge gegeben, und andererseits unterliegt der Schaltungsentwurf Einschränkungen dahingehend, daß pn-Übergänge nur in einer Spannungsrichtung sperren, den Strom aber in der invertierten Spannungsrichtung leiten. Die Begrenzung der maximal zulässigen Kristalltemperatur dieser Bauelemente ist zusätzlich durch das im Vergleich zum Volumen des eigentlichen Bauelements, z.B. Transistor, große umgebende Volumen des Kristallmaterials gegeben. Der durch die Kristalltemperatur verursachte unerwünschte Transistorleckstrom hat ab einer Temperatur von etwa 130°C seine überwiegende Ursache nicht mehr nur in der Erzeugung von Elektron-Loch-Paaren in den Raumladungszonen der gesperrten pn-Übergänge selbst, sondern überwiegend in jenen Elektron-Loch-Paaren, die in der Nachbarschaft des pn-Übergangs erzeugt werden, zu diesem diffundieren und zum Sperrstrom beitragen.

Es ist es im Stand der Technik bekannt, daß diese Begrenzungen dadurch hinausgeschoben bzw. ganz aufgehoben werden können, wenn anstelle der Isolation durch pn-Übergänge eine dielektrische Isolation eingeführt wird, bei der die die integrierte Schaltung bildenden Einzelbauelemente jeweils vollständig von einem Isolator umgeben sind.

Diese Art der Isolation ist im Stand der Technik bekannt, jedoch im allgemeinen nur aufwendig erreichbar.

Zu diesem Zweck sind kommerziell erhältliche sogenannte Silicon On Insulator Silizium Wafer (SOI-Silizium Wafer; SOI = Silicon On Insulator = Silizium auf Isolator) erhältlich, bei deren Verwendung zur Herstellung integrierter Schaltungen eine dielektrische Isolation zum Grundmaterial hin gegeben ist. In diesem Fall fungiert das Grundmaterial lediglich als mechanischer Träger.

Die laterale dielektrische Isolation kann z.B. durch die sogenannte Mesatechnik erreicht werden, jedoch mit dem Nachteil von großen topographischen Höhenunterschieden nach der Mesaätzung. Diese Topologie ist innerhalb moderner VLSI- und ULSI-Prozesse (VLSI = Very Large Scale Integration = Höchstintegration; ULSI = Ultra Large Scale Integration = Ultrahöchstintegration) nicht tragbar und daher ohne zusätzliche aufwendige Planarisierungs- und Einebnungsmaßnahmen inkompatibel.

Im Stand der Technik hat sich daher zur Lösung des Problems der lateralen dielektrischen Isolation die sogenannte Grabenisolations- oder Trench-Isolationstechnik durchgesetzt. Hierbei wird in einem aus technisch-physikalischen Randbedingungen heraus geringstmöglich machbaren Abstand ein Graben in die einkristalline Halbleiternutzschicht geätzt, der von der Scheibenoberfläche bis zur Begrenzung der einkristallinen Halbleiternutzschicht reicht. Der Graben umgibt die Einzelbauelemente oder Gruppen von Einzelbauelementen in der Form einer geschlossenen Begrenzung. Zur Beseitigung der durch die Grabenätzung entstandenen Höhenunterschiede und zur Erreichung einer dauerhaften Isolationseigenschaft ist es notwendig, den Graben mit elektrisch isolierendem Material zu füllen, oder die Grabenwände mit einem elektrisch isolierenden Material zu überziehen und den verbleibenden Restgraben mit semi-isolierendem, Halbleiter- oder leitfähigem Material aufzufüllen.

Als Materialien kommen hierbei nur diejenigen in Frage, die mit den anschließenden Halbleiter-technologischen Fertigungsschritten verträglich sind. Angewendet wird beispielsweise die vollständige thermische Aufoxidation des Grabens, die teilweise thermische Aufoxidation der Grabenwände und zusätzliche Auffüllung des Restgrabens beispielsweise mittels eines Siliziumdioxids, dotierten Siliziumdioxids, Polysilizium oder amorphes Silizium, die alle mittels eines konform abscheidenden CVD-Verfahrens (CVD = Chemical Vapour Deposition = Chemische Abscheidung aus der Gasphase) abgeschieden werden. Ist das abgeschiedene Material isolierend, so kann es auch alleine zur Füllung des Grabens verwendet werden. Im Regelfall ist anschließend an das CVD-Verfahren ein anisotroper Rückätzschritt notwendig.

Die oben beschriebenen bekannten Verfahren zur Erzeugung einer Grabenisolation weisen eine Mehrzahl von Nachteilen auf. Diese Nachteile bestehen darin, daß
- die Prozeßführung aufwendig ist,
- Einzelprozeßschritte verwendet werden müssen, die hohe Anforderungen an die verwendete Ausrüstung und an die Einstellungen der verwendeten Geräte stellen,
- hohe Anforderungen bezüglich der Verfahrenstoleranzen gestellt werden,
- Einzelprozeßschritte verwendet werden, die nicht kompatibel zu den in einer CMOS-Herstellung bestehenden Anforderungen sind,
- eine Mehrzahl von zusätzlichen Lithographieschritten benötigt wird,
- hohe Anforderungen bezüglich der Justiergenauigkeit von aufeinanderfolgenden Maskenschritten erforderlich sind,
- zusätzlich zu den durchzuführenden Standard-CMOS-Verfahrensschritten die zur Grabenherstellung notwendigen Zusatzschritte mit hohem Zusatzaufwand ausgeführt werden müssen, und
- ein hoher lateraler Platzbedarf für die Isolation erforderlich ist.

Die EP 0 656 651 A2 betrifft ein Verfahren zur Herstellung einer integrierten Schaltungsanordnung, bei dem in einer Substratscheibe in einem zweistufigen Grabenprozeß eine Grabenstruktur hergestellt wird. In einem ersten Ätzschritt wird eine Grabenmaske erzeugt und in einem zweiten Ätzschritt wird die Grabenstruktur in der Substratscheibe erzeugt. Dann erfolgt eine Auffüllung der Grabenstruktur durch ganzflächiges Abscheiden einer amorphen Siliziumschicht, wodurch sich Siliziumspacer ausbilden. Anschließend werden durch Oxidation der Siliziumspacer SiO2-Spacer gebildet, und der verbleibende Zwischenraum zwischen den Spacern wird durch eine Siliziumfüllung aufgefüllt, welche aufoxidiert wird, um die Grabenstruktur mit einem Abschluß zu verschließen. Die Auffüllung des Grabens erfolgt nicht durch eine lokale Oxidationstechnik.

Die WO 93/10559 betrifft ein Verfahren zur Herstellung von tiefen Gräben in Halbleitersubstraten, die mit Isolationsmaterial gefüllt sind. In ein entsprechend vorbereitetes Substrat wird ein Graben geätzt, der in einem nachfolgenden Schritt an seinen Wänden mit einem dielektrischen Material ausgekleidet wird. Anschließend wird eine dicke Polysiliziumschicht über das gesamte Substrat abgeschieden, wodurch auch der Graben mit dem Polysilizium gefüllt wird. Der Graben wird somit nicht durch eine lokale Oxidationstechnik gefüllt.

Ausgehend von diesem Stand der Technik liegt der vorliegenden Erfindung die Aufgabe zugrunde, ein Verfahren zum Erzeugen einer Grabenisolation in einem Substrat zu schaffen, das eine einfache Prozeßführung sicherstellt und das eine Reihe von notwendigen Teilprozeßschritten ohne Zusatzaufwand mit ohnehin durchzuführenden Standard CMOS-Verfahrensschritten ausführt.

Diese Aufgabe wird durch ein Verfahren nach Anspruch 1 gelöst.

Gegenüber dem weiter oben beschriebenen Stand der Technik weist die vorliegende Erfindung eine Mehrzahl von Vorteilen auf, die darin bestehen, daß
- die Prozeßführung einfach ist;
- Einzelprozeßschritte verwendet werden, die möglichst geringe Anforderungen an die Ausrüstung stellen, die damit auf möglichst einfache und gleichermaßen zuverlässige Weise die Erzeugung einer Grabenisolation ermöglichen,
- Einzelprozeßschritte verwendet werden, die möglichst geringe Anforderungen an die Einstellung der Maschinen stellen,
- möglichst geringe Anforderungen an die Prozeßtoleranzen gestellt werden (große Prozeßfenster),
- Einzelprozeßschritte verwendet werden, die kompatibel zu den in einer CMOS-Herstellung angetroffenen Anforderungen sind,
- nur ein einziger zusätzlicher Lithographieschritt notwendig ist,
- keine unüblich hohen Anforderungen an die Justiergenauigkeit aufeinanderfolgender Maskenschritte und dadurch erzwungene Maskenvorhalte notwendig sind,
- die zeitliche Abfolge der bezüglich der Grabenerzeugung spezifischen Zusatzschritte so gewählt ist, daß Teilaufgaben ohne Zusatz aufwand mit ohnehin durchzuführenden Standard-CMOS-Verfahrensschritten automatisch mitdurchgeführt werden,
- ein geringer lateraler Platzbedarf für die Isolation erforderlich ist,
- zukünftige Vorteile gegenüber bekannten Verfahren ersichtlich sind, wenn im Verlauf der absehbaren technischen Entwicklung die in der Produktion verwendeten Lithographiemaße weiter verkleinert werden.

Bevorzugte Weiterbildungen der vorliegenden Erfindung sind in den Unteransprüchen definiert.

Nachfolgend wird anhand der beiliegenden Zeichnungen ein bevorzugtes Ausführungsbeispiel der vorliegenden Erfindung näher beschrieben. Es zeigen:

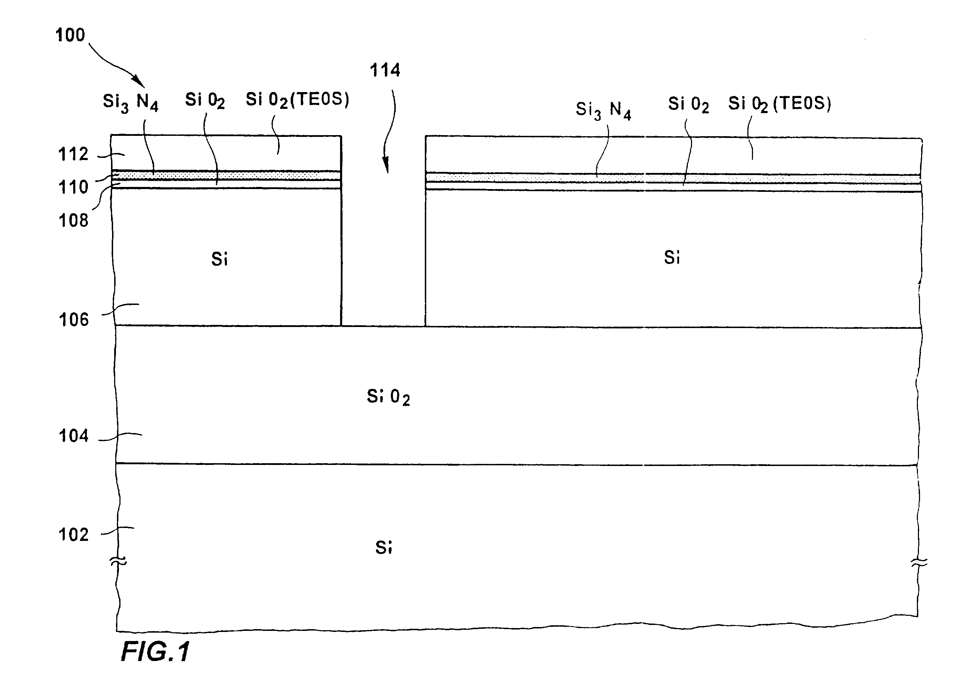

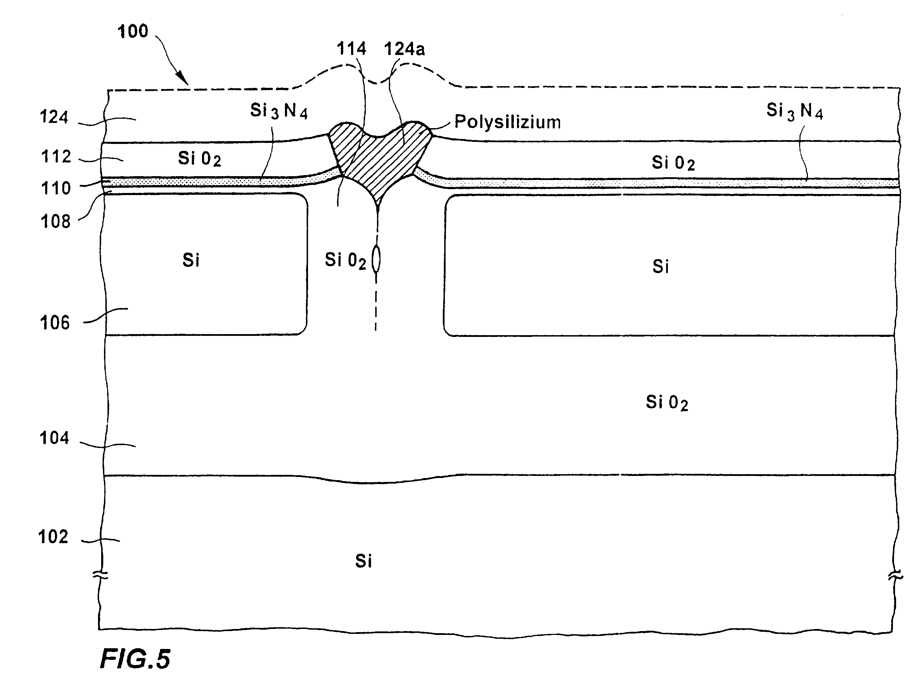

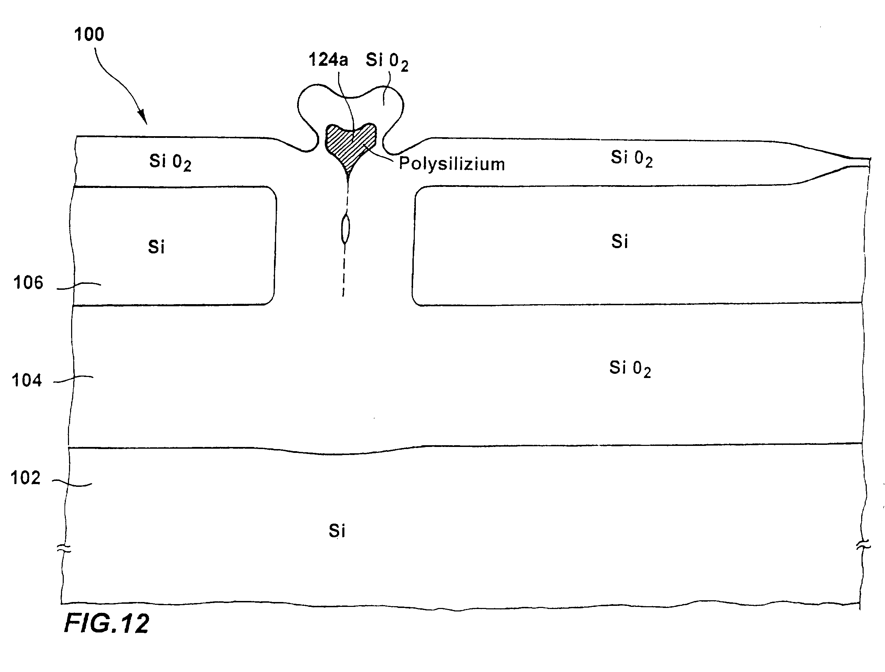

- Fig. 1 bis 18: Herstellungsschritte zur Erzeugung eines Bauelements in ein Halbleitersubstrat, bei dem eine Grabenisolation gemäß dem erfindungsgemäßen Verfahren erzeugt wird.

Es wird darauf hingewiesen, daß in allen Figuren für entsprechende Schichten, Komponenten etc. gleiche Bezugszeichen verwendet werden.

Das nachfolgend beschriebene erste Ausführungsbeispiel des erfindungsgemäßen Verfahrens befaßt sich mit einer Grabenisolationstechnik, bei der die im SOI-Material verbleibende Schichtdicke lateral um das Bauelement herum durch einen Graben bzw. Trench abgetrennt wird. Der Graben wird von der Oberfläche bis auf die unter der aktiven Kristallschicht liegenden Isolatorschicht geätzt und mit isolierenden Material aufgefüllt, so daß am Ende eine weitgehend planare Oberfläche der Gesamtanordnung bzw. Gesamtschaltung entsteht.

Als Ausgangsmaterial für das nachfolgend beschriebene Ausführungsbeispiel wird eine spezielle Art eines SOI-Grundmaterials verwendet, nämlich ein sogenanntes BESOI-Material (BESOI = Back Etched Silicon On Insulator = zurück geätztes Silizium auf Isolator), das weltweit von einer zunehmenden Anzahl von Herstellern angeboten wird.

Der Trend der technischen Entwicklung auf diesem Gebiet geht zu einer Verfügbarkeit eines Materials mit immer kleineren Schichtdickentoleranzen und damit auch immer kleiner werdenden, großtechnisch herstellbaren dünnen Nutzschichten.

Der Vorteil gegenüber einem alternativen Herstellungsverfahren für ein SOI-Material ist die gute Kristallqualität der Nutzschicht, die Qualität und die Variationsmöglichkeit der darunter liegenden Silizium-Dioxid-Schicht und die relative Preisgünstigkeit.

Bei dem nachfolgend beschriebenen Ausführungsbeispiel wird ein BESOI-Material verwendet, das eine Nutzschichtdicke von etwa 2 ± 0,5 µm und eine darunter liegende Silizium-Dioxid-Schicht (SiO₂-Schicht) mit einer Dicke von 2 µm aufweist.

Dieses Material war zum Zeitpunkt der Erfindung kommerziell erhältlich.

Ein in Zukunft erhältliches dünneres Material mit entsprechend kleineren Dickentoleranzen kommt dem nachfolgend beschriebenen Verfahrensablauf bei Niederleistungsanwendungen sowohl hinsichtlich verbesserter Bauelementeigenschaften als auch einer erleichterten Prozeßführung entgegen.

Das bei diesem bevorzugten Ausführungsbeispiel verwendete BESOI-Material weist in einer Nutzschicht (Bond) einen spezifischen Widerstand von 17 bis 33 Ω cm auf, der aufgrund der bei Prozeßende erwünschten Eigenschaften des hergestellten Transistors auf diesen Wert eingestellt ist. Dieses BESOI-Material ist als C 500 BESOI bekannt.

In einem ersten Prozeßabschnitt I erfolgt eine Vorbereitung zur Erzeugung einer unstrukturierten Schichtfolge

In einem ersten Verfahrensschritt S1 wächst eine Prenitrid-oxidschicht bzw. Pad-Oxidschicht mit einer Dicke von 40nm auf der Vorderseite des BESOI-Materials, im folgenden als Schichtfolge bezeichnet, bei einer Temperatur von 950°C in trockener sauerstoffhaltiger Athmosphäre auf.

In einem zweiten Verfahrensschritt S2 wird eine Nitrid-schicht mit einer Dicke von 100 nm auf der Vorder- und Rückseite der Schichtfolge mittels eines LPCVD-Verfahren (LPCVD - Low Pressure Chemical Vapor Deposition = Niederdruckabscheidung aus der Gasphase) abgeschieden.

In einem dritten Verfahrensschritt S3 wird eine Oxidschicht mittels eines TEOS-LPCVD-Verfahrens auf die auf der Vorder- und Rückseite der Schichtfolge aufgebrachten Nitridschicht abgeschieden (TEOS = Tetraethylorthosilicat). Die Oxidschicht wird mit einer Dicke von 200 nm abgeschieden und wird auch als Abscheideoxidschicht bezeichnet, die zum Schutz der Oberfläche der im Verfahrensschritt S2 aufgebrachten Nitridschicht dient.

In einem vierten Verfahrensschritt S4 wird die Nitridschicht von der Rückseite der Schichtfolge entfernt. Hierbei dient das abgeschiedene Oxid als Kontaminationsschutz, wenn beim Ätzen der Rückseite der Schichtfolge die Vorderseite der Schichtfolge auf der Auflage bzw. auf dem Chuck der Ätzanlage aufliegt.

Ein nasses Ätzen der Rückseite der Schichtfolge ist mittels eines konventionellen Beckentauchverfahrens auf direkten Wegen nicht möglich, da fertigungskompatible organische Abdeckschichten gegenüber der heißen Phosphorsäure nicht beständig sind.

Die Anforderungen der Selektivität dieses Ätzprozesses sind denkbar gering. Es muß lediglich die Abscheideoxidschicht (Schritt S3) und die Nitridschicht (Schritt S2) vollständig durchgeätzt werden.

Ein Überätzen in das Trägersilizium der Schichtfolge, das eine Dicke von wenigstens 0,5 mm aufweist, ist im Rahmen der "nonuniformity" bzw. der Unregelmäßigkeit auch sehr einfacher Maschinen unschädlich.

In einem fünften Verfahrensschritt S5 wird die Schichtfolge gereinigt.

In einem sechsten Verfahrensschritt S6 wird die Abscheideoxidschicht auf der Vorderseite der Schichtfolge durch Eintauchen der Schichtfolge in eine flußsäurehaltige Ätzlösung entfernt. Die flußsäurehaltige Ätzlösung wird aufgrund der hohen Selektivität der Flußsäure (HF) gegenüber der Nitrid-schicht verwendet. Anschließend wird die Schichtfolge mit VE-Wasser (deionisiertes Wasser) gespült, getrocknet und bei 750°C ausgeheizt, um adsorbierte Wassermoleküle zu entfernen.

In einem siebten Verfahrensschritt S7 wird eine erste Oxidschicht mittels eines TEOS LPCVD-Verfahrens mit einer Dicke von 470 nm auf der im Schritt S2 abgeschiedenen Nitrid-schicht abgeschieden. Diese Oxidschicht dient als sogenannte Hard-Mask für eine nachfolgende Grabenätzung.

Das Ziel des im vorhergehenden beschriebenen ersten Prozeßabschnitts I war es, eine lateral zunächst noch unstrukturierte Schicht 100 zu erzeugen, wie es in der rechten Hälfte von Fig. 1 dargestellt ist. Die Schichtfolge 100 umfaßt
- einen einkristallinen Siliziumträgerwafer 102;
- eine vergrabene Siliziumdioxidschicht 104 (SiO₂-Schicht);
- eine gedünnte einkristalline Bauelement-Nutzschicht 106;
- eine Standard-"Pad-Oxidschicht" 108 zum Spannungsausgleich bei der nachfolgenden lokalen Oxidation;
- eine Siliziumnitridschicht 110 (Si₃N₄-Schicht) zur Bildung einer Nitridmaske bei einer nachfolgenden lokalen Oxidation;
- eine Abscheide-Siliziumdioxid-Schicht (SiO₂-Schicht) 112, die bei einer nachfolgenden Grabenätzung als Maske bzw. "Hard-Mask" dient.

Auf der Rückseite der Schichtstruktur 100 befindet sich nur noch die Abscheidesiliziumdioxidschicht (SiO₂-Schicht) - nicht dargestellt.

In einem nachfolgenden Prozeßabschnitt II erfolgt die Strukturierung der Siliziumdioxidschicht 112 als Grabenmaske und das Ätzen des Grabens.

In einem achten Verfahrensschritt S8 wird eine Fotolackschicht bzw. ein Fotoresist auf die erste Oxidschicht 112 aufgebracht. Es wird darauf hingewiesen, daß je schmaler der Graben geätzt werden kann, desto kürzer und günstiger wird der nachfolgende Prozeßablauf. Hierbei wirken sich technische Fortschritte zukünftiger Verfahrensgenerationen günstig auf das erreichbare Endergebnis aus.

In einem neunten Verfahrensschritt S9 wird die Maske bzw. Hard-Mask geätzt. Hierzu wird die im Verfahrensschritt S8 aufgebrachte Fotolackschicht entsprechend strukturiert und an den Stellen, an denen der Graben zu erzeugen ist, wird die freiliegende Abscheideoxidschicht 112 mittels eines anisotropen Oxid-Plasmaätzverfahrens bis auf die einkristalline Siliziumnutzschicht 106 geätzt.

Es wird darauf hingewiesen, daß es sich bei diesem Plasmaätzverfahren für Siliziumdioxid um eine Standardtechnik handelt, wie sie z.B. beim Öffnen von Kontaktlöchern bei der Siliziumschaltkreisproduktion üblich ist.

Die den trockenen Oxidätzverfahren eigene, geringe Selektivität gegenüber Nitrid führt dazu, daß auch die Nitrid-schicht 110 mitstrukturiert wird. Dies ist hier erwünscht. Ein Überätzen in die Siliziumnutzschicht 106 ist an dieser Stelle für das gewünschte Endergebnis unschädlich.

In einem zehnten Verfahrensschritt S10 wird nach dem Strukturieren der Maske bzw. Hard-Mask die noch verbliebene Fotolackrestschicht mit einer Sauerstoffplasmabehandlung entfernt. Zusätzlich kann es hierbei notwendig sein, verbliebene Polymere mit einem naßchemischen Stripper zu entfernen.

In einem elften Verfahrensschritt S11 wird mittels eines anisotropen Chlorplasma-Trockenätzverfahrens der eigentliche Graben 114 in die einkristalline Nutzschicht 106 geätzt.

Es wird darauf hingewiesen, daß das oben beschriebene anisotrope Chlorplasma-Trockenätzverfahren beispielsweise zur Strukturierung von Polysilizium-Gate-Elektroden oder bei einem Ätzprozeß, wie der bei der Herstellung von Grabenzellen bei dynamischen RAM-Speichern (RAM = Random Access Memory = Speicher mit wahlfreiem Zugriff) verwendet wird.

Als Maskierungsschicht dient hierbei die strukturierte Oxidschicht 112 auf der Oberfläche der Schichtfolge 100.

Die vergrabene thermische Siliziumdioxidschicht 104 dient hierbei als Ätzstopp in der Tiefe des Grabens.

Die Selektivität eines Chlorplasma-Ätzverfahrens beträgt etwa 10 : 1 bis 20 : 1, d.h. die Ätzrate ist in Silizium 10 mal höher als in SiO₂. Dies gewährleistet ein großes Prozeßfenster, wobei Toleranzen bei der Ätzzeit, der Ätzrate und der lateralen Gleichmäßigkeit über der Schichtfolge 100 aufgefangen werden.

Die sich nach dem Prozeßabschnitt II ergebende Struktur ist in Fig. 1 dargestellt.

Ein Prozeßabschnitt III umfaßt lediglich den zwölften Verfahrensschritt S12, in dem der Graben 114 aufoxidiert wird.

Ein wesentliches Merkmal der vorliegenden Erfindung besteht darin, daß während der Aufoxidation des Grabens 114 die strukturierte Abscheideoxidschicht 112 "Hard-Mask" unverändert auf der Schichtfolge 100 verbleibt.

Die Schichtfolge wird nun in einem thermischen Oxidationsverfahren in einer Wasserdampfatmospähre aufoxidiert, bis sich der Graben 114 aufgefüllt hat. Charakteristisch für diese thermische Oxidation ist, daß die entstehenden Schichtdicken in etwa zu gleichen Teilen durch Aufbrauch des oxidierten Siliziums und durch den von außen zugeführten Sauerstoff entsteht. Die Oxidationszeit muß daher mindestens so eingestellt werden, daß auf eine mitoxidierte blanke Siliziumscheibe eine Oxidschichtdicke von der einfachen Breite des Grabens aufwächst. Bei einer Grabenbreite von 1 µm, was mit heutigem Lithographieverfahren sicher erreichbar ist, muß eine 1 µm dicke Oxidschicht aufwachsen. Bei einer Grabenbreite von 0,8 µm, was mittels moderner Belichtungsverfahren erreichbar ist, muß analog nur noch eine 0,8 µm dicke Oxidschicht aufwachsen. Daraus ist ersichtlich, daß bei diesem Verfahren der derzeitige Trend in der Halbleitertechnik hin zu kleineren Abmessungen einen technischen Vorteil bedingt, im Gegensatz zu Füllverfahren mittels einer konformen Abscheidung aus der Gasphase, wie es dem Stand der Technik entsprechen würde.

Bei nicht idealen, d.h. nicht vollständig reaktionsbegrenzten, konformen Abscheidungsverfahren besteht die Neigung, den näher an der Oberfläche gelegenen Teil des Grabens schneller zu füllen als den tieferliegenden Teil. Die Folge ist, daß der Graben an der Oberseite bereits verschlossen ist, und im unteren Teil ein kapillarförmiger Hohlraum, ein sogenannter Lunker, zurückbleibt.

Das bei dem hier beschriebenen Ausführungsbeispiel verwendete Aufoxidationsverfahren ist bei den hier vorhandenen Geometrien nahezu ideal reaktionsbegrenzt und führt dann sicher nicht zu Lunkern, wenn der Graben keine negativen Flankenwinkel aufweist.

Bei der fortschreitenden thermischen Oxidation von Silizium muß der Sauerstoff durch die bereits aufgewachsene SiO₂-Schicht hindurch an die Grenzfläche Silizium-SiO₂ diffundieren. Erst dort erfolgt die chemische Reaktion. Diffusionsbarrieren, wie bei dem hier beschriebenen Ausführungsbeispiel die zurückgebliebene Abscheideoxidschicht 112 der "Hard-Mask" und zum wesentlichen Teil die Si₃N₄-Schicht ermöglichen es, daß die hier verwendete lokale Oxidation zum konformen gleichmäßigen Auffüllen nur der Gräben führt.

Das Aufoxidationsverfahren der Grabenwände ist selbstbegrenzend, da die Nachfüllung von Sauerstoff aus der Oxidationsatmosphäre automatisch um Größenordnungen verringert wird, sobald sich die Schichtfronten von beiden Seiten des Grabens in der Mitte berühren.

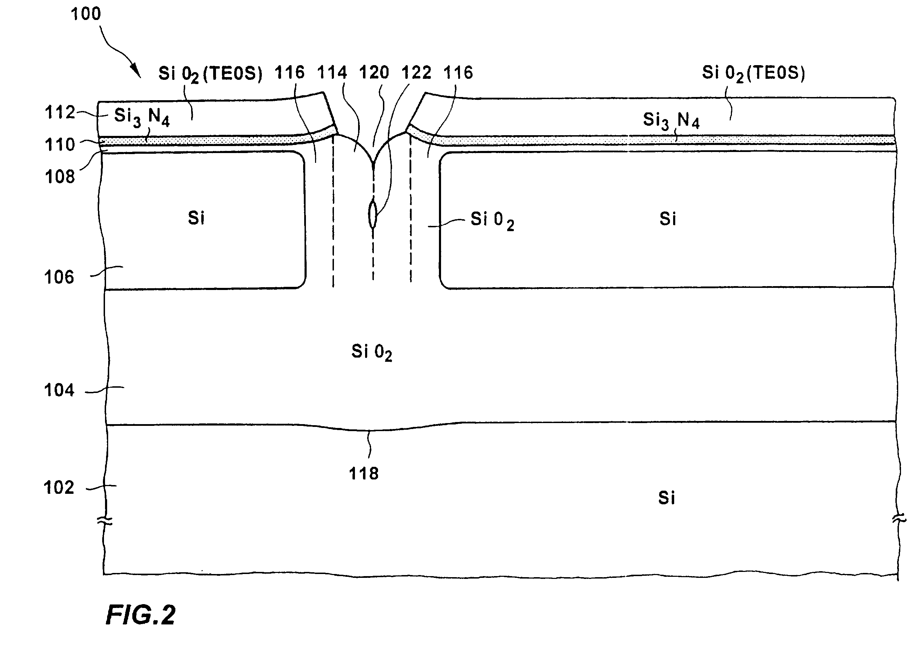

Der sich aufgrund der Auffüllung des Grabens ergebende Zustand der Schichtfolge 100 ist in Fig. 2 dargestellt. Die SiO₂-schicht 116 an den Grabenwänden ist zur Hälfte unter die ursprünglich vorhandene, den Graben begrenzende Maske gewachsen. Die gestrichelte Linie in Fig. 2 zeigt die Abmessungen des ursprünglichen Grabens 114.

An der neuen lateralen Begrenzung des Grabens hat sich an der Oberseite unterhalb der Si₃N₄-Schicht 110 der seit langem aus der lokalen Oxidationstechnik (LOCOS) bekannte sogenannte Vogelschnabel oder "Birdsbeak" ausgebildet, und die Maske an ihrer Kante nach oben, d.h. von der Vorderseite der Schichtfolge weg, gebogen.

An der dem Graben gegenüberliegenden Grenzfläche der Siliziumträgerschicht 102 ist etwas Oxid zusätzlich aufgewachsen, was zu der in Fig. 2 dargestellten Auswölbung 118 der vergrabenen Oxidschicht 104 führt.

Die beiden zuletzt beschriebenen Phänomene und die Kantenverrundung an der Grabenunterseite haben ihre Ursache in den oben beschriebenen Sauerstoff-Diffusionsmechanismen.

In der Mitte des nun aufgefüllten Grabens sind zwei Problemzonen erkennbar, die der Grund dafür sind, daß dieses zunächst einfache Verfahren nicht ohne weiteres angewendet werden konnte.

Die erste Problemzone ist der sogenannte "Zwickel" 120 an der Oberseite der Schichtfolge 100. In diesem können sich bei nachfolgenden Prozeßschritten Chemikalienreste und Partikel festsetzen und bei einem Polysilizium-Gate-Verfahren unbeabsichtigt leitfähige Bahnen bilden, die Kurzschlüsse und damit Schaltungsausfälle hervorrufen können. Die zweite Problemzone ist die unter Umständen noch vorhandene "Nahtstelle" 122, an denen die beiden Oxidschichten 116 zusammengewachsen sind. In diese Nahtstelle können durch Kapillareffekte flußsäurehaltige Ätzsäurelösungen eindringen, deren Anwendung in der CMOS-Technologie unvermeidbar ist. Ist diese Ätzlösung einmal eingedrungen, so läßt sie sich kaum noch entfernen und richtet durch eine unerwünschte Ätzkorrosion bleibende Schäden während des weiteren Herstellungsprozesses und später an den fertigen Schaltungen an.

Es ist kein durchführbares Verfahren bekannt, um die Hard-Mask wieder zu entfernen. Trotz ihrer hohen Selektivität gegenüber Si₃N₄ scheiden flußsäurehaltige Ätzlösungen aus, da sie durch den bevorzugten Angriff im Bereich des Zwickels 120 den Graben wieder teilweise entfüllen würden.

Anisotrope Oxidätzverfahren sind gegenüber Sᵢ3N₄ zu unselektiv und würden das ungünstige Profil des Zwickels bestehen lassen.

Es wird darauf hingewiesen, daß verschieden Oxidationsverfahren oder Kombinationen bekannter Oxidationsverfahren zur Auffüllung des Grabens mit einem Oxid anwendbar sind. Ein erstes mögliches Verfahren ist die Auffüllung des Grabens durch ein CVD-Oxid. Eine weitere Möglichkeit ist die Auffüllung durch thermische Oxidation. Wiederum eine weitere Möglichkeit ist die teilweise Auffüllung des Grabens mittels thermischer Oxidation und das Auffüllen des restlichen Graben mit einem CVD-Oxid, oder umgekehrt.

In einem nachfolgenden Prozeßabschnitt IV werden die oben beschriebenen Nachteile ausgeräumt.

In einem drei zehnten Verfahrensschritt S13 wird zur Umgehung der durch die Auffüllung des Grabens entstandenen Probleme zeitlich unmittelbar anschließend, ohne jeglichen weiteren Zwischenschritt, eine Schicht 124 aus undotiertem Polysilizium aus der Gasphase in einem konform arbeitenden LPCVD-Prozeß abgeschieden.

Ein Polysilizium-Abscheidungsprozeß ist Bestandteil jedes modernen Polysilizium-Gate-Gesamtprozesses und daher in jeder einschlägigen Fertigung bekannt.

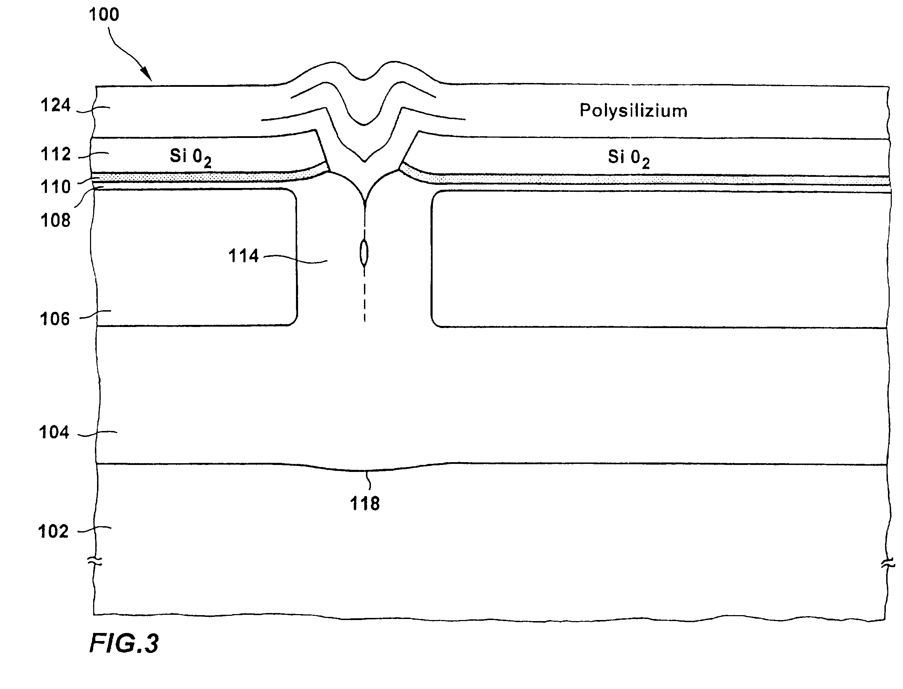

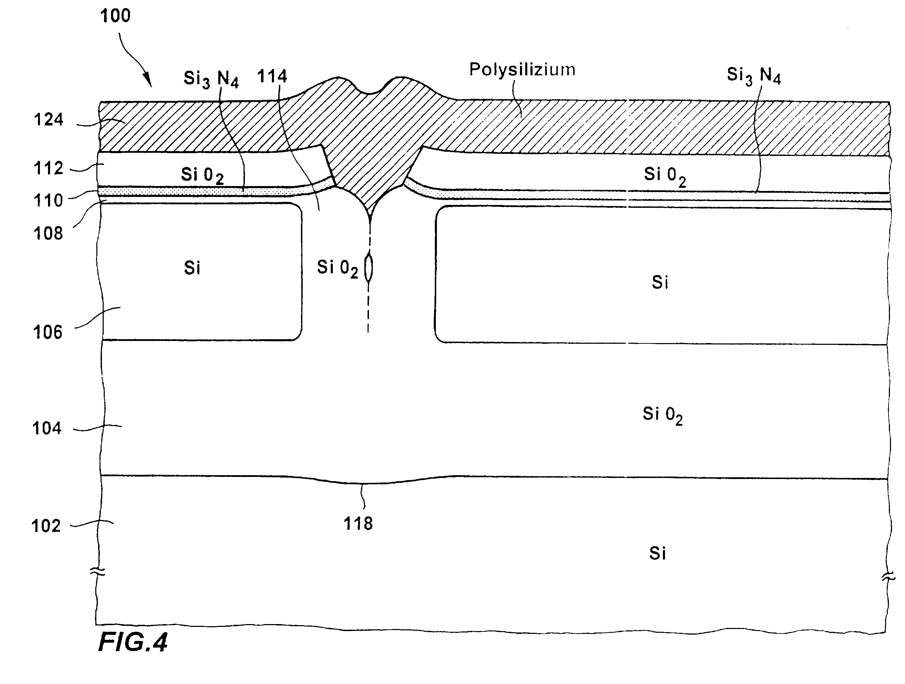

Die Anwendung ist hier unkritisch, da hier keine Kante mit überhängenden Flanken (negativer Flankenwinkel) vorkommt. Für die geätzte Grabenbreite von 1 µm erweist sich eine abgeschiedene Schichtdicke von 0,7 bis 0,8 µm als zweckmäßig. Der nun erreichte Fertigungszustand ist in Fig. 3 bzw. Fig. 4 dargestellt.

Es wird darauf hingewiesen, daß dieser Schritt der konformen Abscheidung des Polysiliziums ein wesentliches Merkmal des vorliegenden erfindungsgemäßen Verfahrens ist.

Durch das konforme Abscheidungsverfahren ist es zunächst gelungen, die spitze, ungünstige Topographie im Bereich des Zwickels 120 zu verrunden und gleichzeitig die Höhenunterschiede auf der Vorderseite der Schichtfolge 100 zu verringern.

Obwohl dies in den Fig. 3 und 4 nicht dargestellt ist, wurde durch das Polysiliziumabscheidungsverfahren auch eine Polysiliziumschicht auf der Rückseite der Schichtfolge 100 abgeschieden.

In einem vierzehnten Verfahrensschritt S14 wird die Polysiliziumschicht auf der Rückseite der Schichtfolge 100 ganzflächig entfernt. Dies erfolgt durch ein Plasmaätzverfahren. Hierbei befinden sich die Scheiben mit ihrer Vorderseite der Schichtstruktur 100 auf dem Chuck der Ätzanlage.

Als Ätzstoppschicht dient das Abscheidungsoxid, das im Verfahrensschritt S7 ebenfalls auf die Rückseite der Schichtfolge 100 aufgebracht wurde.

In einem fünfzehnten Verfahrensschritt S15 wird ohne jeden weiteren Zwischenschritt die abgeschiedene Polysiliziumschicht 124 maskenlos mittels eines anisotropen Chlorplasma-Ätzverfahrens wieder abgeätzt. Dies kann in derselben Anlage geschehen, die für die Strukturierung von Gate-Elektroden verwendet wird, oder kann dieselbe Anlage sein, die für die Grabenätzung verwendet wurde.

Die Selektivität dieses Siliziumätzverfahrens liegt im Bereich von 1 : 10 bis 1 : 20 gegenüber der noch auf der Vorderseite der Schichtstruktur 100 verbleibenden Abscheideoxidschicht 112.

Damit ist ein sicherer Ätzstopp und die Immunität gegenüber einer fertigungsüblichen Unregelmäßigkeit (nonuniformity) gegeben.

Die Si₃N₄-Schicht 110 bleibt somit unbeschädigt erhalten.

Das anisotrope Ätzverfahren trägt die zu ätzende Schicht 124 überwiegend in Richtung senkrecht zur Scheibenoberfläche gleichmäßig ab.

In Fig. 5 ist die sich ergebende einebnende Wirkung der Rückätzung der Polysiliziumschicht 124 dargestellt. Hierbei ist die ursprüngliche Oberfläche gestrichelt eingezeichnet.

In Fig. 6 zeigt den Zustand der Schichtfolge 100 nach Beendigung des Verfahrensschritts S15.

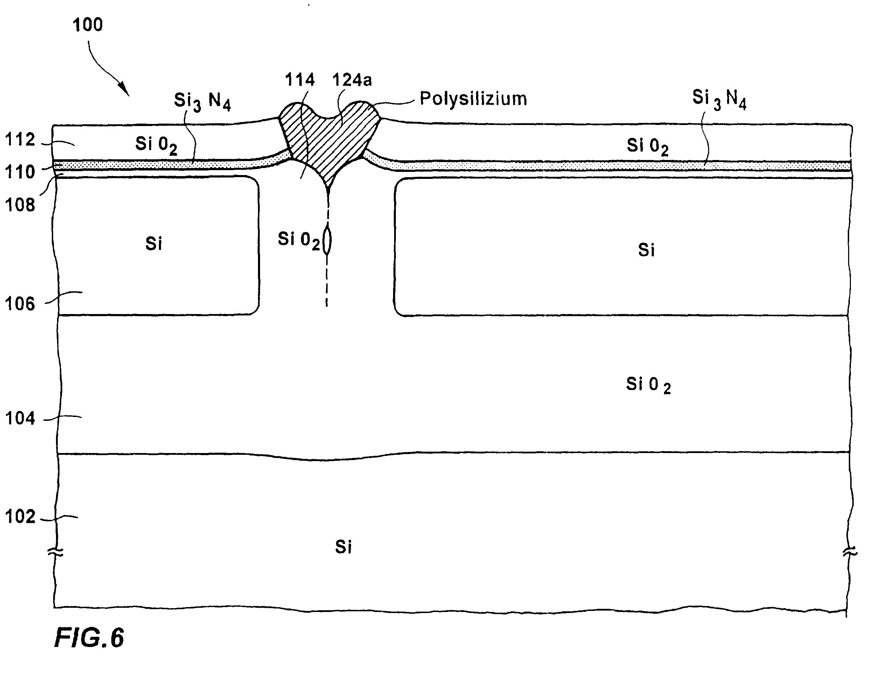

Wie es der Fig. 6 zu entnehmen ist, führt die Anwendung des oben beschriebenen anisotropen Rückätzschrittes S15 zu einer Einebnung des Grabenzwickels 116 und zur Bildung einer Polysiliziumabdeckung 124a des oxidgefüllten Grabens 114.

Es wird darauf hingewiesen, daß die Bildung der Polysilizium-Abdeckung 124a auf dem oxidgefüllten Graben 114 ein wesentliches Merkmal der vorliegenden Erfindung ist.

In einem Verfahrensschritt S16 wird die zurückgebliebene Maske nun durch ein einfaches naßchemisches Beckentauchätzverfahren in flußsäurehaltiger Ätzlösung entfernt.

Als Monitor für das Ende des Ätzverfahrens dient die Rückseite der Schichtfolge 100, bei der eine Hydrophobie erreicht werden muß.

Flußsäurehaltige Ätzlösungen besitzen sowohl gegenüber Silizium als auch gegenüber Si₃N₄ eine Selektivität von jeweils Wenigstens 1 : 100.

Somit ist eine problemlose Entfernung der Hard-Mask, die aus der Abscheideoxidschicht 112 gebildet ist, möglich.

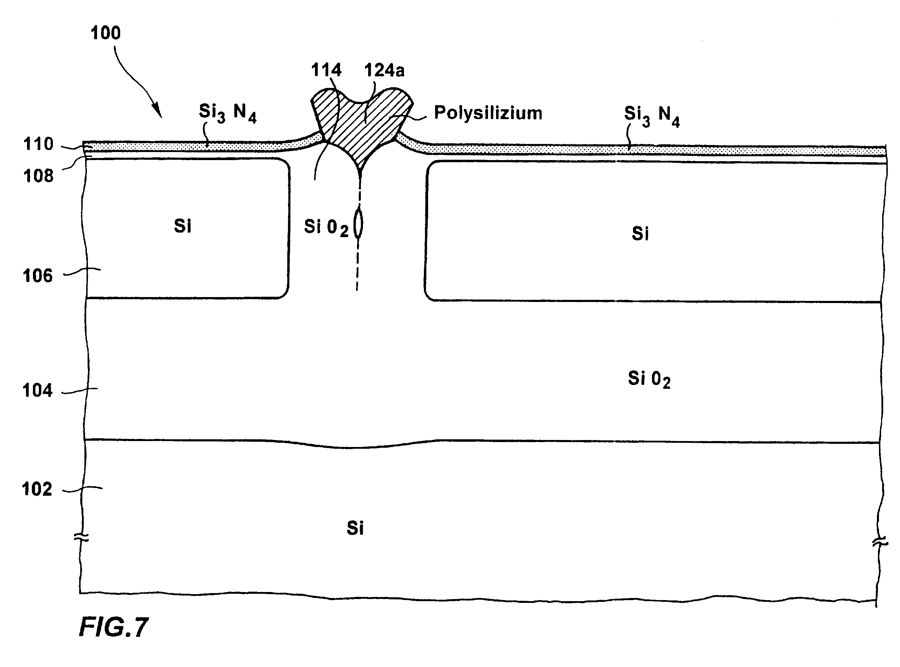

Der Zustand der Schichtfolge 100 nach dem Entfernen der Abscheideoxidschicht ist in Fig. 7 dargestellt.

Anhand der im vorhergehenden beschriebenen Prozeßabschnitte I bis IV wurde das erfindungsgemäße Verfahren zur Erzeugung einer Grabenisolation beschrieben.

Hierbei wurde einerseits ein mit einem Isolatormaterial gefüllter Graben hergestellt und andererseits gleichzeitig eine vollständige Abdeckung und teilweise Planarisierung dieses Grabens mit einem Material erreicht, das weitgehend resistent gegenüber den in einem CMOS-Prozeß unvermeidlichen flußsäurehaltigen naßchemischen Ätzlösungen ist. Somit ergeben sich gegenüber herkömmlichen Verfahren die folgenden Vorteile:
- die Entfernung der für das Grabenätzen erforderlichen Maske ist problemlos möglich,
- der Graben ist mit Siliziumdioxid aufgefüllt und in diesem Fertigungszustand trotzdem in einer Weise abgedeckt, daß CMOS-kompatible und notwendige naßchemische Ätz- und Reinigungsschritte in fertigungsüblicher Weise verwendet werden können, ohne daß die Integrität der Grabenfüllung gefährdet ist, und
- die Si₃N₄-Schicht ist erhalten geblieben, so daß anschließend an den Fertigungszustand, der in Fig. 7 dargestellt ist, mit einer herkömmlichen CMOS-Prozeßführung die endgültige integrierte Schaltung gefertigt werden kann.

Es wird darauf hingewiesen, daß die verbleibende Polysilizium-Abdeckung 124a des Grabens im schlechtesten Fall relativ weit über die Vorderseite der Schichtfolge hinausragt. Dies ist jedoch nur ein vorübergehender Zwischenzustand, da in dem folgenden, herkömmlichen CMOS-Prozeßablauf mehrere Oxidations- und selektive Oxidätzschritte vorkommen, die am Prozeßende zu einer weitgehend planaren Oberfläche der Schichtfolge 100 führen.

Nachfolgend wird im Prozeßabschnitt V die endgültige integrierte Schaltung fertiggestellt.

In einem siebzehnten Verfahrensschritt S17, der eine Fototechnik zur Strukturierung der Si₃N₄-Schicht 110 zur Herstellung von Dickoxidgebieten mittels lokaler Oxidation betrifft, wird eine übliche Trockenätzung der Si₃N₄-Schicht 110 durchgeführt.

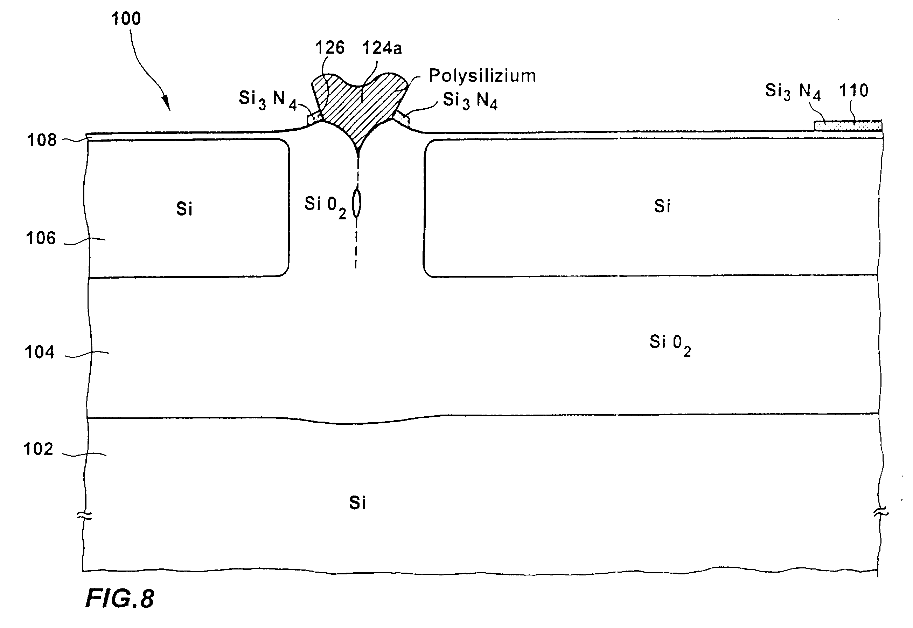

Der Fertigungszustand ist in Fig. 8 dargestellt.

Um auch den schlimmsten Fall zu berücksichtigen, wurde für den weiteren Prozeßverlauf angenommen, daß bei dem anisotropen Nitridätzverfahren durch die "Schattenwirkung" der Polysiliziumabdeckung 124a des Grabens 114 ein Rand 126 aus Si₃N₄ übrigbleibt.

Vor einem achtzehnten Verfahrensschritt werden bei der CMOS-Fertigung einige Dotierstoffvorbelegungsschritte mittels Ionenimplantation und Lackmasken durchgeführt, die in Fachkreisen an sich bekannt sind.

Bei einer weitverbreiteten Prozeßfamilie ist es üblich, der lokalen Oxidation zur Herstellung der Dickoxidgebiete ein ähnliches LOCOS-Teilverfahrenmodul voran zustellen, das es ermöglicht, selbstjustierend die Definition der globalen n- und p-dotierten Gebiete vorzunehmen (das sogenannte Twin-Tub-Verfahren).

Auf dieses aufwendige Verfahrensmodul kann bei der Anwendung der erfindungsgemäßen Grabenisolation verzichtet werden. Bei dem hier beschriebenen Ausführungsbeispiel wurde der Graben 1 µm breit geätzt und hat im gefüllten Zustand eine Breite von 2 µm. Erfolgt die Definition der globalen n- und p-dotierten Gebiete mittels Lackimplantationskmasken und wird beim Maskenentwurf die Lackkante jeweils auf die Grabenmitte gelegt, darf die Summe aus Kantenfehler und Justierfehler ± 1 µm betragen.

Dieser Wert kann mit der heute weit verbreiteten Stepperlithographietechnik ohne weiteres erreicht werden.

Somit wird der durch die Grabenisolationstechnik notwendige höhere Aufwand durch die damit mögliche Prozeßvereinfachung teilweise kompensiert.

In einem achzehnten Schritt S18 wird eine Feldoxidation beispielsweise in einer feuchten Sauerstoffatmospähre bei 1000°C durchgeführt. Die angestrebte Oxiddicke beträgt hier z.B. 650 nm.

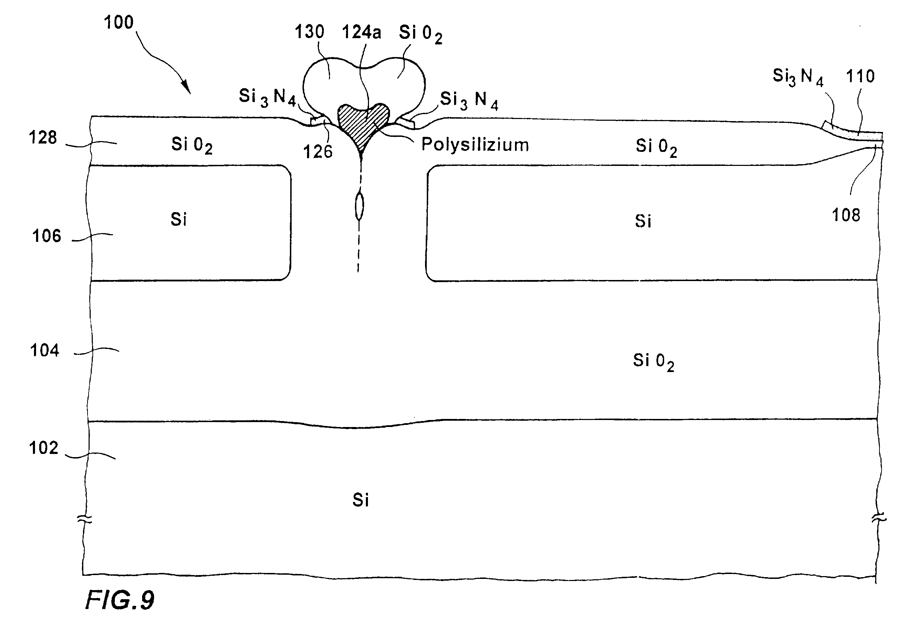

Wie es der Fig. 9 zu entnehmen ist, wurde neben der Oxidation des einkristallinen Siliziums 106 (SiO₂-Schicht 128) auch der über die Vorderseite der Schichtfolge 100 herausragende Grabendeckel 124a mitoxidiert (siehe Schicht 130).

Etwa 350 nm des Grabendeckels 124a wurden für die Bildung des Oxids 130 an seinen der Atmosphäre ausgesetzten Oberflächen aufgebraucht.

In einem nachfolgenden neunzehnten Verfahrensschritt S19 wird die Nitrid-Oxidationsmaske 110 vollständig entfernt. Dies erfolgt üblicherweise durch ein naßchemisches Tauchätzverfahren in heißer Phosphorsäure bei 160°C.

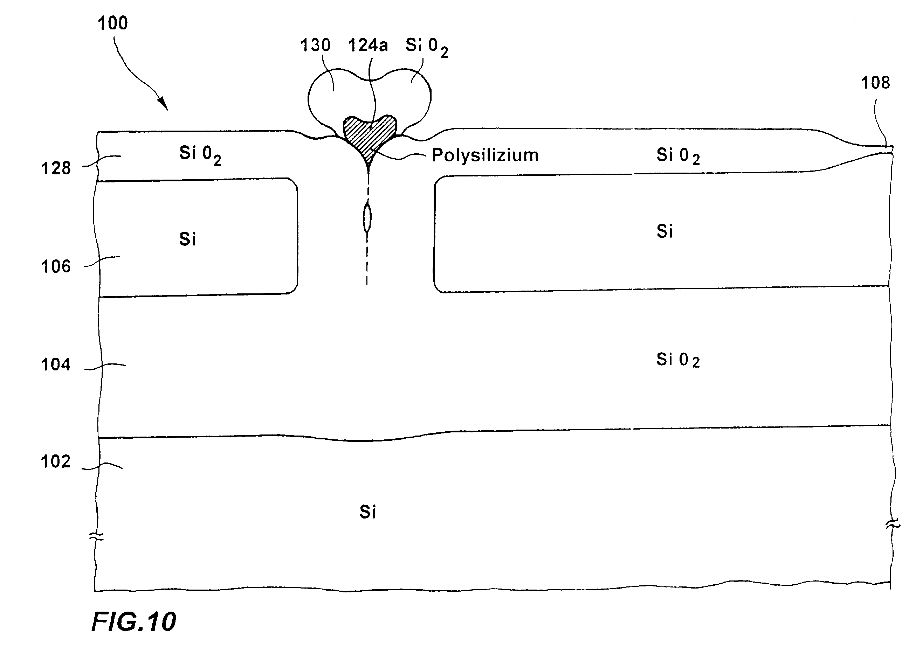

Der Fertigungszustand ist in Fig. 10 dargestellt. Wie Fig. 10 ebenfalls zu entnehmen ist, wurden auch die noch eventuell zurückgebliebenen Si₃N₄-Reste (126, Fig. 9) an den Rändern des Grabendeckels 124a, 130 beseitigt.

Anschließend erfolgt eine sorgfältige Spülung der Schichtfolge 100 in VE-Wasser (deionisiertes Wasser).

Wie es in Fig. 10 zu sehen ist, wurde durch die Entfernung der Nitridschicht 110 die durch diese Nitridschicht während der Feldoxidation im Schritt S18 geschützte Pad-Oxidschicht 108 freigelegt.

In einem einundzwanzigsten Verfahrensschritt S21 wird die Prenitrid-Oxidschicht (Pad-Oxidschicht) 108 geätzt. Hierzu wird eine vorbestimmte Schichtdicke in einem naßchemischen Tauchätzverfahren in flußsäurehaltiger Ätzlösung gleichmäßig an allen SiO₂-Oberflächen 128, 110 abgetragen.

Das Ziel ist es, in den Dünnoxidgebieten 132 bis auf das blanke einkristalline Silizium der Siliziumnutzschicht 106 zu ätzen.

Anschließend erfolgt eine sorgfältige Spülung in VE-Wassesr.

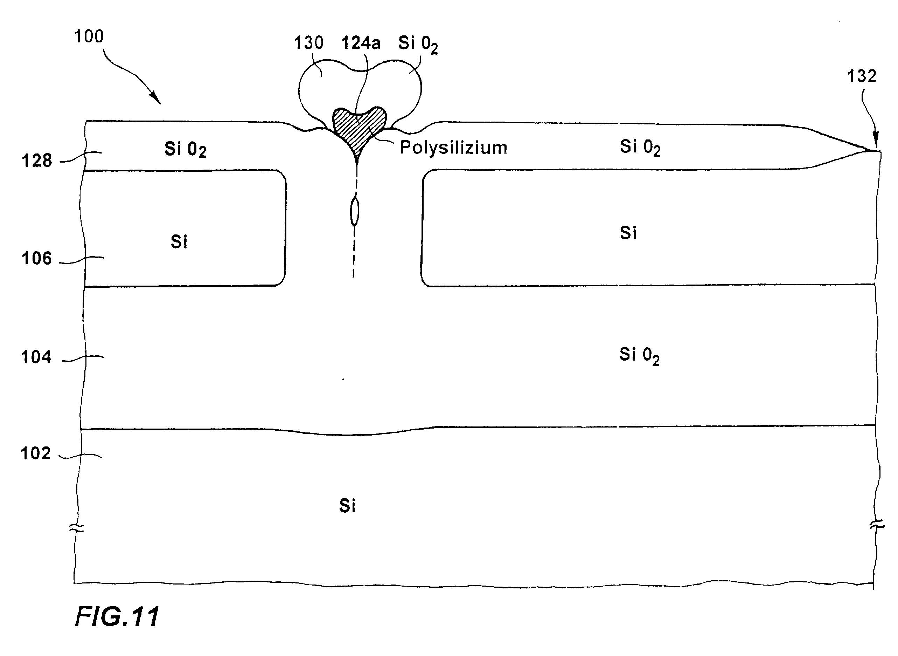

Der erreichte Fertigungszustand ist in Fig. 11 dargestellt.

In einem zweiundzwanzigsten Verfahrensschritt S22 wird zur Unterdrückung des sogenannten "White Ribbon"-Artefakts die nun freiliegende einkristalline Siliziumschicht 106 in einer feuchten Sauerstoffatmospähre bei 1000°C oxidiert.

Das Ziel ist es, eine Oxiddicke auf dem blanken Silizium von 100 nm zu erreichen.

Fig. 11 zeigt den sich ergebenden Zustand, der sich prinzipiell nicht von dem Zustand unterscheidet, wie er anhand von Fig. 10 dargestellt ist.

Dieser Schritt wird auch als "Opfer-Oxidations-Schritt" bezeichnet.

In einem dreiundzwanzigsten Verfahrensschritt S23 wird die "Opfer-Oxid-Schicht" entfernt. Hierzu wird in einem naßchemischen Tauchätzverfahren in flußsäurehaltige Ätzlösungen an allen SiO₂-Oberflächen eine vorbestimmte Schichtdicke abgetragen. Das Ziel besteht darin, in dem Dünnoxidgebiet bis auf das blank liegende einkristalline Silizium der Siliziumnutzschicht 106 zu ätzen.

Als Monitor kann hierbei die am Prozeßendpunkt eingetretene Hydrophobie der Rückseite der Schichtfolge dienen.

Anschließend erfolgt eine sorgfältige Spülung in VE-Wasser.

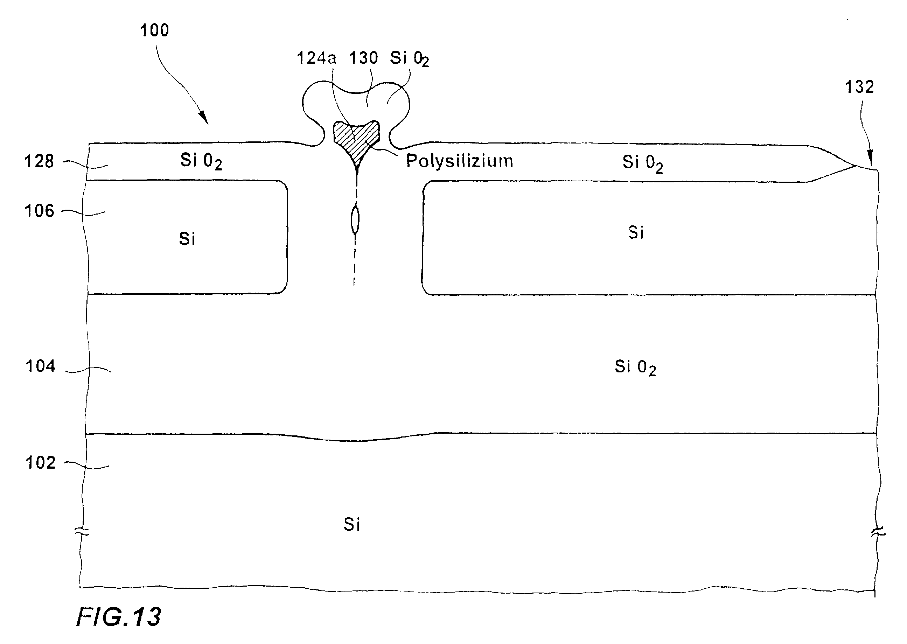

Der erreichte Fertigungszustand ist in Fig. 13 dargestellt, der sich prinzipiell nicht von dem in Fig. 11 dargestellten Zustand unterscheidet.

Es wird jedoch darauf hingewiesen, daß das mehrmalige Ätzen der gesamten Silizium-Dioxid-Oberflächen eine Verkleinerung des SiO₂-Anteils des Grabendeckels bewirkt.

In einem vierundzwanzigsten Verfahrensschritt S24 wird mittels einem Oxidationsverfahren in trockener Sauerstoffatmospähre bei z.B. 950°C ein beispielsweise 55 nm dickes Gate-Oxid 134 auf die freiliegenden Siliziumflächen aufgewachsen.

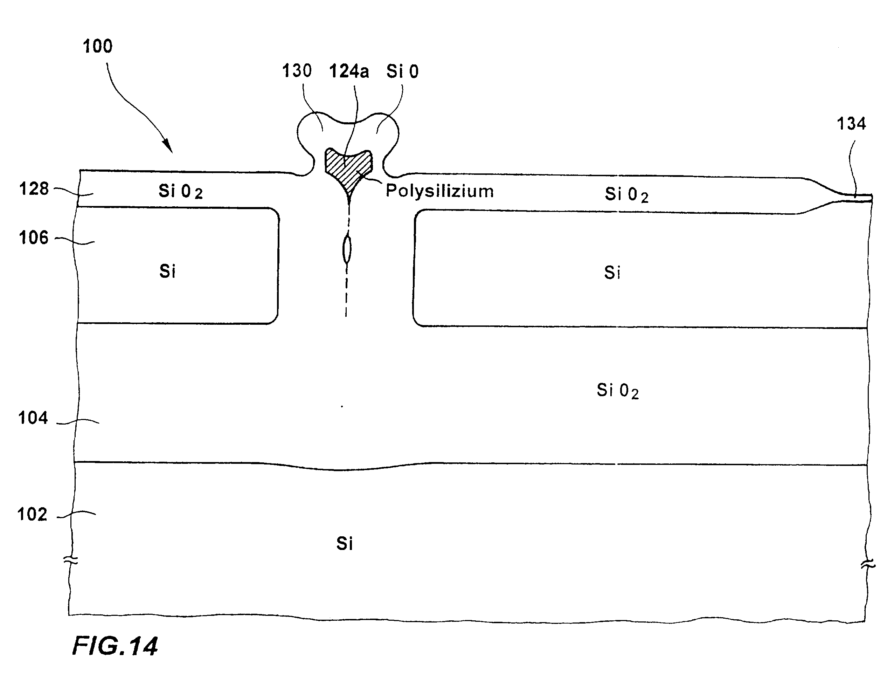

Der Fertigungszustand ist in Fig. 14 dargestellt, der sich rein optisch nicht von den Fig. 13 und 11 unterscheidet.

In einem fünfundzwanzigsten Verfahrensschritt S25 erfolgt eine Schwellspannungsimplantation. Diese Implantation, die an sich bekannt ist, hat keinen Einfluß auf den Graben. Am Ende wird eine im allgemeinen 5 nm dicke Oxidschicht gleichmäßig naßchemisch im Zusammenhang mit den erforderlichen Reinigungsschritten abgetragen.

In einem sechsundzwanzigsten Verfahrensschritt S26 wird eine Polysiliziumschicht 136 auf der SiO₂-Schicht 128 und der Grabenabdeckung 124a, 130 sowie auf der Gate-Oxidschicht 134 abgeschieden.

Diese Abscheidung erfolgt mit derselben Anlage, die zur Abscheidung der ersten Polysiliziumschicht 124 mittels eines konformen LPCVD-Verfahrens verwendet wurde.

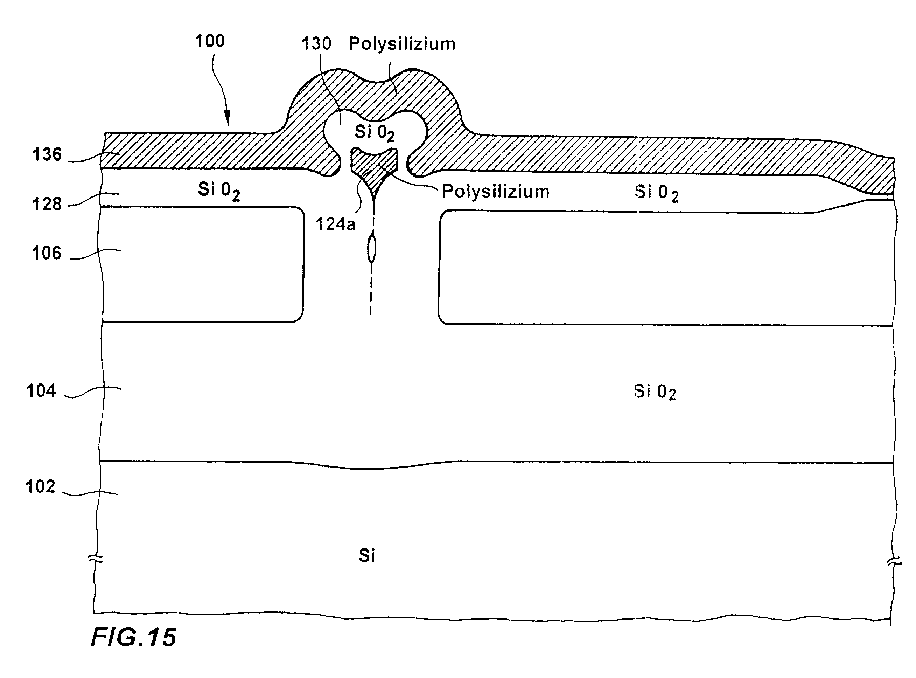

Der sich ergebende Fertigungszustand ist in Fig. 15 dargestellt. Das konforme Abscheidungsverfahren bewirkt eine Einebnung der Oberfläche der Schichtfolge 100 im Bereich der Ränder der Grabenabdeckung.

In einem siebenundzwanzigsten Verfahrensschritt S27 wird das im Schritt S26 abgeschiedene Polysilizium dotiert, da dies nach der Strukturierung als Gate-Elektrode dient. Es ist eine Phosphordotierung aus der Gasphase erforderlich, um die Polysiliziumschicht 136 ausreichend leitfähig zu machen.

In einem achtundzwanzigsten Verfahrensschritt S28 erfolgt die Sturkturierung der Polysilizium-Gate-Elektroden. Die Strukturierung erfolgt durch eine Fotolackmaske mittels dem im vorangegangenen Prozeßablaufs schon zwei mal angewendeten anisotropen Chlorplasma-Trockenätzverfahrens.

Als Ätzstopp wirkt hierbei die darunterliegende SiliziumDioxidschicht 128.

Die Selektivität dieses Verfahrens gegenüber Siliziumdioxid beträgt etwa 1 : 20.

Das Verfahren ist in Fachkreisen an sich bekannt und bildet in der MOS-Technologie ein Standardverfahren.

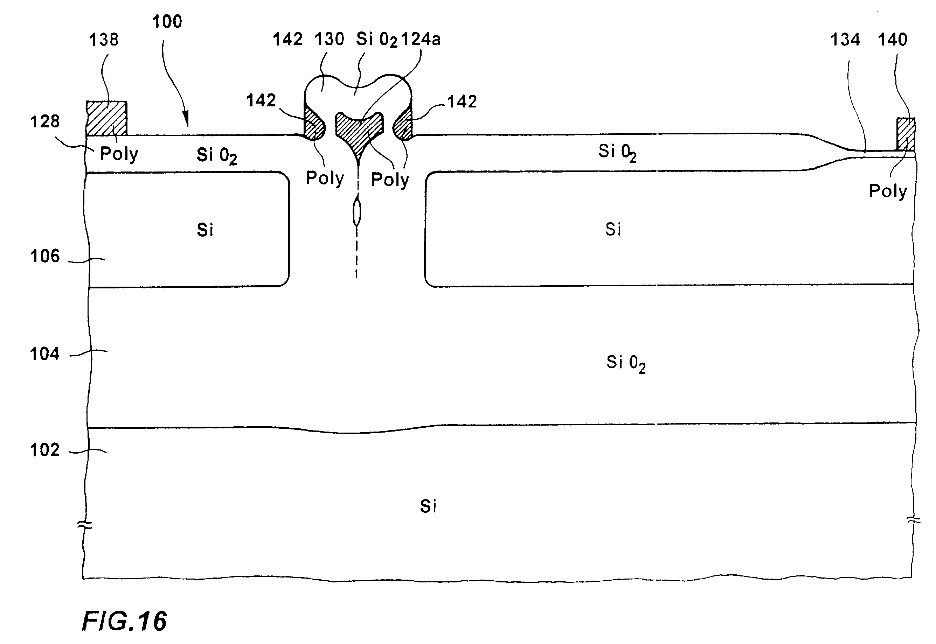

Fig. 16 zeigt den sich einstellenden Fertigungszustand.

Links ist ein Teil einer Polysiliziumleiterbahn 138 auf Feldoxid, rechts ein Teil einer Gate-Elektrode 140 auf dünnem Gate-Oxid 134 dargestellt.

In der Mitte ist die Auswirkung dieses Prozeßschritts S28 auf die Form der Grabenabdeckung dargestellt. Die Zeichnung ist bezüglich der Schichtdicke und der lateralen Abmessungen im Grabenbereich maßstäblich. Es ist zu erkennen, daß die Topographie im Bereich des Grabendeckels nur geringfügig größere Höhenunterschiede aufweist als in den Bereichen der Gates und Polysiliziumleiterbahnen. Die Topographie in den beiden letztgenannten Gebieten ist an sich bekannt, und alle Halbleiterhersteller müssen damit zurechtkommen, bzw. wenden entsprechende Planarisierungsmaßnahmen zur Erleichterung der nachfolgenden Prozeßschritte an.

Wie es Fig. 16 zu entnehmen ist, bleibt auch im Bereich des Grabendeckels ein Teil 142 der im Schritt S26 abgeschiedenen Polysiliziumschicht 138 zurück.

Ein neunundzwanzigster Verfahrensschritt S29 beschäftigt sich mit der Herstellung von Source-Drain-Gebieten oder allgemein mit der Source-Drain-Technologie.

In diesem Schritt werden eine Reihe von Lackimplantationsmasken, Ionenimplantationen und zwischengeschaltete Reinigungs- und Oxidationsschritte, gegebenenfalls noch eine Spacertechnologige zur Herstellung der n- und p-Source/Drain-Inseln und der Ohmschen Kontakte zu den globalen n- und p-dotierten Bereichen durchgeführt.

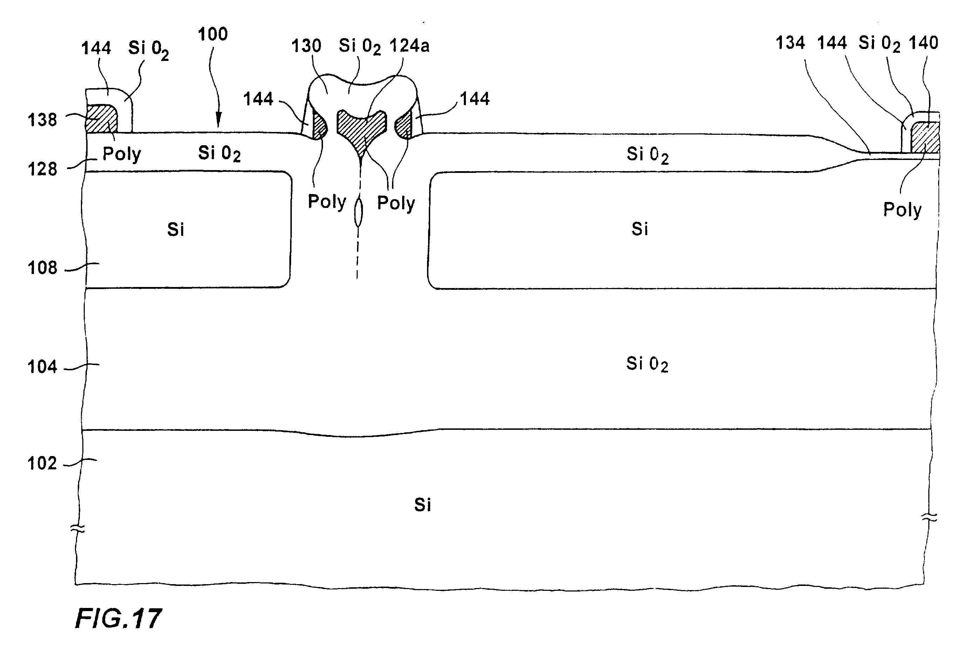

Die Auswirkung, abgesehen von den erzeugten Dotierungsprofilen, zeigt Fig. 17.

Sichtbar ist lediglich, daß die Polysiliziumgebiete 138, 140, 142 eine thermische Oxidation erfahren haben, durch die eine Oxidschicht 144 aufwuchs.

In einem dreißigsten Verfahrensschritt S30 wird ein Zwischenisolator abgeschieden, und eine Planarisierung durch Verfließen des Zwischenisolators bewirkt.

Zusätzlich zu der auf der Polysiliziumschicht 138, 140, 142 bereits schon befindlichen thermischen Oxidschicht 144 wird im allgemeinen noch ein Zwischenisolator, zunächst eine undotierte Abscheideoxidschicht, wie z.B. diejenige, die zu Beginn als Hard-Mask verwendet wurde und anschließend ein im Prozentbereich mit Phosphor und Bor-dotiertes SiO₂ (PBSG) aus der Gasphase abgeschieden.

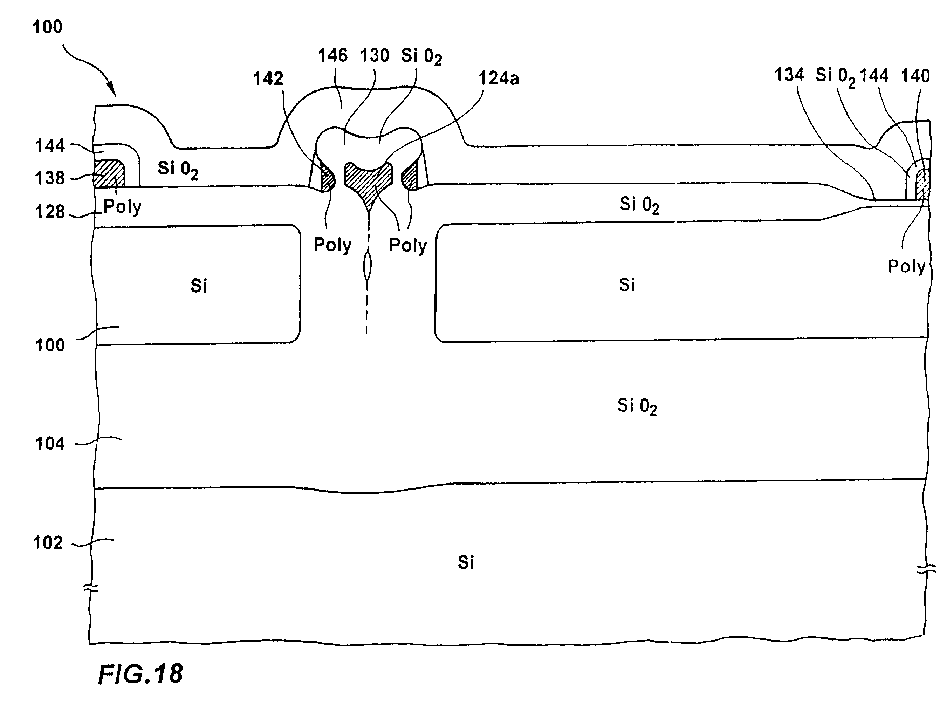

Das PBSG 146 kann in einem Verfließschritt bei z.B. 900°C die steilen Flanken der Polysiliziumkante verflachen. (Siehe Fig. 18).

Dies bewirkt eine Verflachung der Seitenwände des Grabendeckels, so daß die nachfolgende Öffnung von Kontaktlöchern und das sogenannte Prozeß "Back end" vollständig so weitergeführt werden können, wie dies in Fachkreisen an sich bekannt ist.

Es wird darauf hingewiesen, daß es sich bei dem im vorhergehenden beschriebenen Verfahren um ein bevorzugtes Ausführungsbeispiel der vorliegenden Erfindung handelt.

Die für das erfindungsgemäße Verfahren wesentlichen Verfahrensschritte schließen jedoch nicht alle oben ausgeführten Verfahrensschritte ein.

Gemäß dem ersten Ausführungsbeispiel umfaßt das erfindungsgemäße Verfahren im wesentlichen den Verfahrensschritt S7, bei dem eine erste Oxidschicht 112 auf einer Vorderseite einer das SOI-Substrat umfassenden Schichtfolge 100 abgeschieden wird (Siehe Fig.1 ); die Verfahrensschritte S8 bis S10, bei denen die erste Oxidschicht 112 strukturiert wird, um eine Maske für eine nachfolgende Grabenerzeugung zu definieren (Fig. 1); den Verfahrensschritt S11, bei dem ein Graben bis zu der Oxidschicht des SOI-Substrats unter Verwendung der Maske geätzt wird (Fig. 1); den Verfahrensschritt S12, bei dem der Graben 114 mit einem Oxid aufgefüllt wird (Fig. 2); den Verfahrensschritt S13, bei dem eine erste Polysiliziumschicht 124 auf der ersten Oxidschicht 112 und auf dem oxidgefüllten Graben 114 abgeschieden wird (siehe Fig. 4); den Verfahrensschritt S15, bei dem die erste Polysiliziumschicht 124 derart entfernt wird, daß auf dem oxidgefüllten Graben 114 eine Polysilizium-Abdeckung 124a zurückbleibt; und den Verfahrensschritt S16, bei dem die erste Oxidschicht 112 entfernt wird (siehe Fig. 7).

Es wird ferner darauf hingewiesen, daß obwohl das bevorzugte Ausführungsbeispiel der vorliegenden Erfindung ein sogenanntes BESOI-Substrat verwendet, auch mittels anderer Verfahren hergestellte SOI-Substrate verwendet werden können.

Nachfolgend werden weitere bevorzugte Ausführungsbeispiele der vorliegenden Erfindung näher beschrieben, die sich gegenüber dem ersten bevorzugten Ausführungsbeispiel in einigen Verfahrensschritten unterscheiden.

Bei einem zweiten bevorzugten Ausführungsbeispiel der vorliegenden Erfindung werden die Verfahrensschritte S4 bis S6 zur Entfernung der Nitrid-Schicht auf der Rückseite der Schichtfolge 100 wie folgt durchgeführt.

Bei diesem Ausführungsbeispiel dient die im Schritt S3 abgeschiedene Oxidschicht als Ätzmaske für das auf der Vorderseite der Schichtfolge 100 zu schützende Nitrid der Nitrid-schicht 110.

In einem Schritt 4.1 wird die Vorderseite der Schichtfolge 100 belackt und die Abscheideoxidschicht auf der Rückseite der Schichtfolge 100 durch Eintauchen in eine flußsäurehaltige Ätzlösung entfernt.

In einem Verfahrensschritt S4.2 wird der Lack auf der Vorderseite entfernt und die rückseitige Nitridschicht wird durch Eintauchen in heiße Phophorsäure entfernt, wobei hierbei die Abscheideoxidschicht auf der Vorderseite der Schichtfolge 100 als Ätzmaske wirksam ist.

Im Verfahrensschritt S4.3 wird die Schichtfolge 100 mit VE-Wasser gespült und im anschließenden Verfahrensschritt S4.4 werden phosphorkontaminierte Oxide auf der Vorder- und Rückseite der Schichtfolge 100 in einer flußsäurehaltigen Ätzlösung entfernt.

Anschließend erfolgt in einem Verfahrensschritt 4.5 eine erneute VE-Wasserspülung und in einem Verfahrensschritt S4.6 wird die Schichtfolge 100 gereinigt. In einem Verfahrensschritt S4.7 erfolgt eine erneute VE-Wasserspülung und ein Trocknen der Schichtfolge 100.

Im abschließenden Verfahrensschritt 4.8. wird die Schichtfolge 100 bei 750°C ausgeheizt, um adsorbierte Wassermoleküle zu entfernen.

Gemäß einem dritten Ausführungsbeispiel der vorliegenden Erfindung werden anstelle der Verfahrensschritte S3 bis S6 die folgenden Verfahrensschritte durchgeführt.

Bei einem Verfahrensschritt S3' wird die Rückseite der Schichtfolge 100 in einer modernen Spin-Ätzmaschine, z.B. einer RST 100, RST 200 von SEZ, geätzt.

Abschließend wird in einem Verfahrensschritt S4' die Schichtfolge 100 bei 750°C ausgeheizt, um adsorbierte Wassermoleküle zu entfernen.

Bei einem vierten Ausführungsbeispiel der vorliegenden Erfindung wird der Verfahrensschritt S14, bei dem die Polysiliziumschicht auf der Rückseite der Schichtfolge 100 ganzflächig abgeätzt wird, durch eine naßchemische Rückseitennätzung auf einer modernen Spin-Ätzmaschine durchgeführt.

Die vorliegende Erfindung ist jedoch nicht auf die Verwendung von SOI-Substraten beschränkt. Vielmehr findet das erfindungsgemäße Verfahren auch bei einfachen Substraten, d.h. in einem sog. Bulk Material, seine Anwendung.

Nachfolgend wird ein fünftes Ausführungsbeispiel kurz beschrieben, bei dem in einem einfachen Substrat eine Grabenisolation erzeugt wird. Das Verfahren gemäß dem fünften Ausführungsbeispiel unterscheidet sich von demjenigen des ersten Ausführungsbeispiels im wesentlichen dadurch, daß anstelle eines SOI-Substrats ein einfaches Substrat verwendet wird, in das der Graben mit einer vorbestimmten Tiefe geätzt wird.

Gemäß dem fünften Ausführungsbeispiel umfaßt das erfindungsgemäße Verfahren im wesentlichen folgende Verfahrensschritte:

In einem ersten Verfahrensschritt wird eine erste Oxidschicht auf einer Vorderseite einer das Substrat umfassenden Schichtfolge abgeschieden. Anschließend wird die erste Oxidschicht strukturiert, um eine Maske für die nachfolgende Grabenerzeugung zu definieren. Nach der Definition der Maske wird ein Graben in das Substrat unter Verwendung der Maske geätzt, wobei der Graben eine vorbestimmte Tiefe aufweist. Die Tiefe des geätzten Grabens ist z.B. durch die Dauer des Ätzvorgangs oder die Steuerung anderer Parameter des Ätzvorgangs eingestellt, wie dies in Fachkreisen an sich bekannt ist. Nach dem Ätzen des Grabens wird dieser mit einem Oxid aufgefüllt und eine erste Polysiliziumschicht wird auf der ersten Oxidschicht und auf dem oxidgefüllten Graben abgeschieden. Anschließend wird die erste Polysiliziumschicht derart entfernt, daß auf dem oxidgefüllten Graben eine Polysilizium-Abdeckung zurückbleibt. Abschließend wird die erste Oxidschicht entfernt.

Das Verfahren gemäß dem fünften Ausführungsbeispiel führt zu einer Graben- bzw. Trenchisolation, bei der eine engere Anordnung, d.h. ein engeres Zusammenrücken, der aktiven Bauelemente möglich ist, als dies mittels der sog. LOCOS-Isolation möglich wäre. Ferner ergeben sich bei der Verwendung des erfindungsgemäßen Verfahrens gegenüber der LOCOS-Isolation verbesserte Isolationseigenschaften.

Die Grabenisolation gemäß dem fünften Ausführungsbeispiel findet beispielsweise auf dem Gebiet der 256-Mbit- oder größeren DRAMs und sich daraus ableitbaren Logikprozessen.

## Patentansprüche

1. Verfahren zum Erzeugen einer Grabenisolation in einem Silizium-Substrat mit folgenden Schritten:
a) Abscheiden einer ersten Silizium-Oxidschicht (112) auf einer Vorderseite einer das Silizium-Substrat umfassenden Schichtfolge (100);
b) Strukturieren der ersten Silizium-Oxidschicht (112), um eine Maske für eine nachfolgende Grabenerzeugung zu definieren;
c) Ätzen eines Grabens (114) mit vorbestimmter Tiefe in dem Silizium-Substrat unter Verwendung der Maske; und
d) Auffüllen des Grabens (114) durch ein Silizium-Oxid (116);
gekennzeichnet durch folgende Schritte:
e) konformes Abscheiden einer ersten Polysiliziumschicht (124) auf der ersten Silizium-Oxidschicht (112) und auf dem Oxid-gefüllten Graben (114);
f) Entfernen der ersten Polysiliziumschicht (124) derart, daß auf dem Oxid-gefüllten Graben (114) eine Polysiliziumabdeckung (124a) zurückbleibt; und
g) Entfernen der ersten Silizium-Oxidschicht (112).

2. Verfahren nach Anspruch 1, dadurch gekennzeichnet,
daß das Silizium-Substrat ein SOI-Substrat ist; und
daß im Schritt c) das Ätzen des Grabens (114) bis zu einer isolierenden Schicht (104) des SOI-Substrats erfolgt.

3. Verfahren nach Anspruch 2, gekennzeichnet durch folgende Schritte vor dem Schritt a):
- Abscheiden einer Pad-Oxidschicht (108) auf der Vorderseite der das SOI-Substrat umfassenden Schichtfolge (100);
- Abscheiden einer Nitridschicht (110) auf der Pad-Oxidschicht (108) und auf der Rückseite der Schichtfolge (100);
- Abscheiden einer zweiten Silizium-Oxidschicht auf der auf der Pad-Oxidschicht (108) und auf der Rückseite der Schichtfolge (100) abgeschiedenen Nitridschicht (110);
- Entfernen der zweiten Silizium-Oxidschicht und der Nitridschicht von der Rückseite der Schichtfolge; und
- Entfernen der zweiten Silizium-Oxidschicht von der Vorderseite der Schichtfolge (100).

4. Verfahren nach Anspruch 3, dadurch gekennzeichnet,
daß der Schritt b) folgende Schritte umfaßt:
- Aufbringen eines Fotoresists auf der ersten Silizium-Oxidschicht (112);
- Strukturieren des Fotoresists, um einen Bereich für eine nachfolgende Maskenstrukturierung festzulegen;
- Strukturieren der Maske für die nachfolgende Grabenerzeugung durch Ätzen der ersten Silizium-Oxidschicht (112), der Nitridschicht (110) und der Pad-Oxidschicht (108); und
- Entfernen des Fotoresists.

5. Verfahren nach einem der Ansprüche 1 bis 4, dadurch gekennzeichnet,
daß der Graben (114) mittels eines Chlorplasma-Trockenätzverfahrens geätzt wird.

6. Verfahren nach einem der Ansprüche 1 bis 5, dadurch gekennzeichnet,
daß die erste Silizium-Oxidschicht (112) durch ein TEOS LPCVD-Verfahren abgeschieden wird.

7. Verfahren nach einem der Ansprüche 1 bis 6, dadurch gekennzeichnet,
daß der Graben (114) mittels eines thermischen Oxidationsverfahrens aufgefüllt wird.

8. Verfahren nach einem der Ansprüche 1 bis 6, dadurch gekennzeichnet,
daß der Graben (114) mittels eines CVD-Oxids aufgefüllt wird.

9. Verfahren nach einem der Ansprüche 1 bis 6, dadurch gekennzeichnet,
daß ein Teil des Grabens (114) mittels eines thermischen Oxidationsverfahrens aufgefüllt wird und der Rest des Grabens durch ein CVD-Oxid aufgefüllt wird.

10. Verfahren nach einem der Ansprüche 1 bis 9, dadurch gekennzeichnet,
daß die erste Polysiliziumschicht (124) mittels eines LPCVD-Verfahrens abgeschieden wird.

11. Verfahren nach einem der Ansprüche 1 bis 10, dadurch gekennzeichnet,
daß die erste Polysiliziumschicht (124) durch ein Ätzverfahren entfernt wird.

12. Verfahren nach einem der Ansprüche 1 bis 11, dadurch gekennzeichnet,
daß die erste Silizium-Oxidschicht (112) durch ein naßchemisches Ätzverfahren entfernt wird.

## Claims

1. Method of producing a trench insulation in a silicon substrate, comprising the following steps:
a) depositing a first silicon-oxide layer (112) on a front surface of a sequence of layers (100) including the silicon substrate;
b) structuring the first silicon-oxide layer (112) so as to define a mask for a subsequent production of a trench;
c) etching a trench (114) with a predetermined depth in the silicon substrate making use of said mask; and
d) filling said trench (114) with a silicon oxide (116);
characterized by the following steps:
e) conforming deposition of a first polysilicon layer (124) on the first silicon-oxide layer (112) and on the oxide-filled trench (114);
f) removing said first polysilicon layer (124) in such a way that a polysilicon cover (124a) remains on said oxide-filled trench (114); and
g) removing the first silicon-oxide layer (112).

2. A method according to claim 1, characterized in
that the silicon substrate is an SOI substrate; and
that in step c) etching of the trench (114) is effected down to an insulating layer (104) of the SOI substrate.

3. A method according to claim 2, characterized by the following steps prior to step a):
- depositing a pad oxide layer (108) on the front surface of the sequence of layers (100) including the SOI substrate;
- depositing a nitride layer (110) on said pad oxide layer (108) and on the back of said sequence of layers (100);
- depositing a second silicon-oxide layer on the nitride layer (110) deposited on said pad oxide layer (108) and on the back of said sequence of layers (100);
- removing the second silicon-oxide layer and the nitride layer from the back of said sequence of layers; and
- removing the second silicon-oxide layer from the front surface of said sequence of layers (100).

4. A method according to claim 3, characterized in
that step b) comprises the following steps:
- applying a photoresist on said first silicon-oxide layer (112);
- structuring said photoresist so as to determine an area for subsequent mask structuring;
- structuring said mask for the subsequent production of a trench by etching the first silicon-oxide layer (112), the nitride layer (110) and the pad oxide layer (108); and
- removing the photoresist.

5. A method according to one of the claims 1 to 4, characterized in
that the trench (114) is etched by means of a chloro-plasma dry etching process.

6. A method according to one of the claims 1 to 5, characterized in
that the first silicon-oxide layer (112) is deposited by a TEOS LPCVD process.

7. A method according to one of the claims 1 to 6, characterized in
that the trench (114) is filled by means of a thermal oxidation process.

8. A method according to one of the claims 1 to 6, characterized in
that the trench (114) is filled by means of a CVD oxide.

9. A method according to one of the claims 1 to 6, characterized in
that part of the trench (114) is filled by means of a thermal oxidation process and that the rest of the trench is filled by a CVD oxide.

10. A method according to one of the claims 1 to 9, characterized in
that the first polysilicon layer (124) is deposited by means of an LPCVD process.

11. A method according to one of the claims 1 to 10, characterized in
that the first polysilicon layer (124) is removed by means of an etching process.

12. A method according to one of the claims 1 to 11, characterized in
that the first silicon-oxide layer (112) is removed by a wet-chemical etching process.

## Revendications

1. Procédé de réalisation d'une tranchée d'isolation dans un substrat de silicium, aux étapes suivantes consistant à:
a) déposer une première couche d'oxyde de silicium (112) sur une face avant d'une couche résultante (100) comportant le substrat en silicium;
b) structurer la première couche d'oxyde de silicium (112), pour définir un masque pour une réalisation successive d'une tranchée;
c) graver une tranchée (114) de profondeur prédéterminée dans le substrat en silicium, en utilisant le masque; et
d) remplir la tranchée (114) par un oxyde de silicium (116);
caractérisé par les étapes suivantes consistant à:
e) déposer de manière conforme une première couche de polysilicium (124) sur la première couche d'oxyde de silicium (112) et sur la tranchée (114) remplie d'oxyde;
f) éliminer la première couche de polysilicium (124), de sorte que sur la tranchée (114) remplie d'oxyde subsiste un recouvrement de polysilicium (124a); et
g) éliminer la première couche d'oxyde de silicium (112).

2. Procédé suivant la revendication 1, caractérisé par le fait
que le substrat de silicium est un substrat SOI; et
qu'à l'étape c), la gravure de la tranchée (114) a lieu jusqu'à une couche isolante (104) du substrat SOI.

3. Procédé suivant la revendication 2, caractérisé par les étapes suivantes, avant l'étape a), consistant à:
- déposer une couche d'oxyde Pad (108) sur la face avant de la couche résultante (100) comportant le substrat SOI;
- déposer une couche de nitrure (110) sur la couche d'oxyde Pad (108) et sur la face arrière de la couche résultante (100);
- déposer une seconde couche d'oxyde de silicum sur la couche de nitrure (110) déposée sur la couche d'oxyde Pad (108) et sur la face arrière de la couche résultante (100);
- éliminer la seconde couche d'oxyde de silicum et la couche de nitrure de la face arrière de la couche résultante; et
- éliminer la seconde couche d'oxyde de silicum de la couche avant de la couche résultante (100).

4. Procédé suivant la revendication 3, caractérisé par le fait que l'étape b) comporte les étapes suivantes consistant à:
- appliquer un photorésiste sur la première couche d'oxyde de silicium (112);
- structurer le photorésiste, pour fixer une zone pour une structuration de masque successive;
- structurer le masque pour la réalisation successive d'une tranchée par décapage de la première couche d'oxyde de silicium (112), de la couche de nitrure (110) et de la couche d'oxyde Pad (108); et
- éliminer le photorésiste.

5. Procédé suivant l'une des revendications 1 à 4, caractérisé par le fait que la tranchée (114) est gravée à l'aide d'un procédé de gravure en sec au plasma de chlore.

6. Procédé suivant l'une des revendications 1 à 5, caractérisé par le fait que la première couche d'oxyde de silicium (112) est déposée par un procédé TEOS LPCVD.

7. Procédé suivant l'une des revendications 1 à 6, caractérisé par le fait que la tranchée (114) est remplie à l'aide d'un procédé d'oxydation thermique.

8. Procédé suivant l'une des revendications 1 à 6, caractérisé par le fait que la tranchée (114) est remplie à l'aide d'un oxyde CVD.

9. Procédé suivant l'une des revendications 1 à 6, caractérisé par le fait qu'une partie de la tranchée (114) est remplie à l'aide d'un procédé d'oxydation thermique et le reste de la tranchée est rempli d'un oxyde CVD.

10. Procédé suivant l'une des revendications 1 à 9, caractérisé par le fait que la première couche de polysilicium (124) est déposée à l'aide d'un procédé LPCVD.

11. Procédé suivant l'une des revendications 1 à 10, caractérisé par le fait que la première couche de polysilicium (124) est éliminée par un procédé de décapage.

12. Procédé suivant l'une des revendications 1 à 11, caractérisé par le fait que la première couche d'oxyde de silicium (112) est éliminée par un procédé de décapage chimique en humide.
